# FASCICULE DE BREVET EUROPEEN

(11) **EP 2 306 641 B1**
(45) Date de publication et mention de la délivrance du brevet: **29.03.2017**
(21) Numéro de dépôt: 10186122.7
(22) Date de dépôt: 01.10.2010
(51) Int. Cl.: H03H 3/02, H03H 9/17

(54) **Procédé de fabrication de résonateur BAW à facteur de qualité élevé**
Herstellungsverfahren eines BAW-Resonators mit hohem Qualitätsfaktor
Method for manufacturing a BAW resonator with high quality factor

(30) Priorité: 01.10.2009 FR 0956858
(43) Date de publication de la demande: 06.04.2011
(73) Titulaire: STmicroelectronics SA, 92120 Montrouge (FR)
(72) Inventeur: Bar, Pierre, 38000 Grenoble (FR); Joblot, Sylvain, 38700 La Tronche (FR); Petit, David, 38100 Grenoble (FR); Carpentier, Jean-François, 38100 Grenoble (FR)
(74) Mandataire: Thibon, Laurent

(56) Documents cités:
- WO-A1-2009/013938
- WO-A1-2009/031358
- US-A1- 2009 045 703
- MOUROT L ET AL: "Band Reject Filter in BAW Technology", MICROWAVE CONFERENCE, 2008. EUMC 2008. 38TH EUROPEAN, IEEE, PISCATAWAY, NJ, USA, 27 octobre 2008 (2008-10-27), pages 349-352, XP031407167, ISBN: 978-2-87487-006-4
- KOBAYASHI H ET AL: "FABRICATION OF PIEZOELECTRIC THIN FILM RESONATORS WITH ACOUSTIC QUARTER-WAVE MULTILAYERS", JAPANESE JOURNAL OF APPLIED PHYSICS, JAPAN SOCIETY OF APPLIED PHYSICS, JP LNKD- DOI:10.1143/JJAP.41.3455, vol. 41, no. 5B, PART 01, 1 mai 2002 (2002-05-01), pages 3455-3457, XP001163738, ISSN: 0021-4922

## Description

### Domaine de l'invention

La présente invention concerne un résonateur à ondes acoustiques de volume, couramment désigné dans la technique par le terme résonateur BAW, de l'anglais "Bulk Acoustic Wave".

### Exposé de l'art antérieur

Un résonateur BAW comporte un coeur résonant, ou résonateur piézoélectrique, constitué de deux électrodes entre lesquelles est disposée une couche en un matériau piézoélectrique. Lorsqu'un champ électrique est appliqué à la couche piézoélectrique par application d'une différence de potentiels entre les électrodes, il en résulte une perturbation mécanique sous la forme d'ondes acoustiques. Ces ondes se propagent dans le résonateur. La résonance fondamentale s'établit lorsque la longueur d'onde acoustique dans le matériau piézoélectrique correspond sensiblement à deux fois l'épaisseur de la couche piézoélectrique.

Un résonateur comporte notamment deux fréquences remarquables :
la fréquence à laquelle l'impédance acoustique du résonateur est la plus faible, couramment appelée fréquence de résonance ; et
la fréquence à laquelle l'impédance acoustique du résonateur est la plus élevée, couramment appelée fréquence d'antirésonance.

Les résonateurs BAW sont généralement formés au-dessus d'un substrat, par exemple sur une tranche de silicium. On prévoit alors un dispositif d'isolation acoustique entre le coeur résonant et le substrat pour éviter la déperdition des ondes acoustiques dans le substrat. Il existe principalement deux types de résonateurs BAW : les résonateurs BAW suspendus et les résonateurs BAW montés sur un substrat.

Les résonateurs BAW suspendus, plus connus sous le nom de FBAR (de l'anglais "Film Bulk Acoustic Wave Resonator") ou TFR (de l'anglais "Thin Film Resonator"), comprennent une couche isolante d'air entre le coeur résonnant et le substrat. Il est donc prévu une cavité dans le substrat ou un pont au dessus du substrat.

Les résonateurs BAW montés sur le substrat, plus connus sous le nom SMR (de l'anglais "Solidly Mounted Resonator"), sont isolés du substrat par un réflecteur accoustique, couramment appelé miroir de Bragg. Ils présentent une structure plus robuste et mieux adaptée aux procédés de fabrication traditionnels.

On s'intéresse ici aux résonateurs BAW à miroir de Bragg.

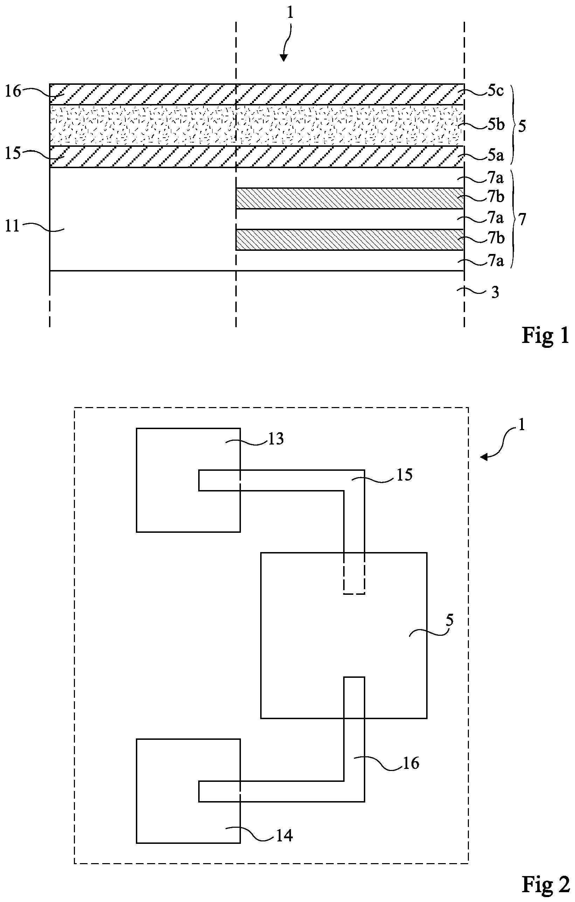

La figure 1 est une vue en coupe représentant de façon schématique un résonateur BAW 1 à miroir de Bragg formé sur un substrat 3. Bien que la figure 1 représente un résonateur unique, dans la pratique, de nombreux résonateurs sont formés simultanément sur une même tranche de substrat.

Le résonateur 1 comprend un résonateur piézoélectrique 5 constitué de l'empilement d'une électrode inférieure 5a, d'une couche 5b d'un matériau piézoélectrique, et d'une électrode supérieure 5c.

Une structure d'isolation 7, par exemple un miroir de Bragg, fait interface entre le résonateur piézoélectrique 5 et le substrat 3. Le réflecteur 7 consiste en un empilement alterné de couches 7a en un matériau à faible impédance acoustique et de couches 7b en un matériau à haute impédance acoustique, chacun de ces matériau étant indifféremment isolant ou conducteur.

L'épaisseur de chaque couche 7a, 7b est choisie sensiblement égale au quart de la longueur d'onde acoustique de résonance dans le matériau qui la compose. A la fréquence de résonance, le réflecteur se comporte comme un miroir acoustique et renvoie les ondes vers le résonateur. La qualité de l'isolation acoustique augmente avec le nombre de couches 7a, 7b de l'empilement alterné. Dans la pratique, on utilise fréquemment des réflecteurs à 4 ou 5 couches.

La figure 2 est une vue de dessus représentant de façon schématique le résonateur BAW 1 de la figure 1. Des plots de contact 13 et 14 sont reliés par des pistes conductrices 15 et 16, aux électrodes inférieure 5a et supérieure 5c du résonateur piézoélectrique 5. Les pistes conductrices 15 et 16 sont représentés de façon simplifiées en figure 1 par un prolongement des électrodes 5a et 5c. La région 11, comprise entre les plots 13 et 14 et pistes 15 et 16, et le substrat 3, est généralement remplie d'oxyde de silicium.

La valeur de la surface occupée par les plots de contact 13 et 14 et par les pistes d'interconnexion 15 et 16 est, en pratique, généralement proche de la surface active du résonateur piézoélectrique 5.

Un inconvénient de la structure décrite ci-dessus est qu'elle présente un facteur de qualité faible par rapport au facteur de qualité théorique d'un résonateur BAW à miroir de Bragg.

On s'intéresse ici à l'amélioration du facteur de qualité, autour de la fréquence d'antirésonance, d'un résonateur BAW destiné à être utilisé dans un oscillateur.

Des exemples de réalisation de résonateurs BAW sont décrits dans les documents US 2009/0045703 et WO 2009/013938.

### Résumé

Un objet d'un mode de réalisation de la présente invention est de pallier tout ou partie des inconvénients des résonateurs BAW à miroir de Bragg classiques.

Un objet d'un mode de réalisation de la présente invention est de proposer un résonateur BAW à miroir de Bragg présentant un facteur de qualité élevé autour de la fréquence d'antirésonance.

Un objet d'un mode de réalisation de la présente invention est de proposer un tel résonateur stable en température.

Un objet d'un mode de réalisation de la présente invention est de proposer un tel résonateur facile à réaliser.

Ainsi, un mode de réalisation de la présente invention prévoit un procédé de fabrication d'une tranche sur laquelle sont formés des résonateurs BAW, chaque résonateur BAW comportant : au dessus d'un substrat, un résonateur piézoélectrique, et à côté du résonateur piézoélectrique, au moins un plot de contact relié à une électrode du résonateur piézoélectrique ; et, entre le résonateur piézoélectrique et le substrat, un miroir de Bragg. Le miroir de Bragg comporte au moins une couche conductrice s'étendant entre le plot et le substrat et au moins une couche supérieure d'oxyde de silicium s'étendant entre le plot et le substrat. Le procédé comporte les étapes successives suivantes : a) déposer la couche supérieure d'oxyde de silicium ; et b) réduire, par gravure au moyen d'un faisceau d'ions balayant la tranche, les inégalités d'épaisseur de la couche supérieure d'oxyde de silicium liées au procédé de dépôt de sorte que cette couche présente une même épaisseur à mieux que 2 % près, et de préférence à mieux que 1 % près, au niveau de chaque plot.

Selon un mode de réalisation de la présente invention, l'étape b) consiste en outre à réduire les inégalités d'épaisseur de la couche supérieure d'oxyde de silicium liées au procédé de dépôt, de sorte que cette couche présente une même épaisseur à mieux que 2 % près, et de préférence à mieux que 1 % près, au niveau de chaque résonateur piézoélectrique.

Selon un mode de réalisation de la présente invention, l'étape b) est réalisée par gravure ionique.

Selon un mode de réalisation de la présente invention, la couche conductrice est en tungstène.

Selon un mode de réalisation de la présente invention, chaque résonateur BAW comporte, superposée à la couche conductrice, une couche en un matériau de conductivité électrique supérieure à celle de la couche conductrice.

Selon un mode de réalisation de la présente invention, le matériau de conductivité électrique supérieure à celle de la couche conductrice est de l'aluminium.

Selon un mode de réalisation de la présente invention, le résonateur piézoélectrique est formé par empilement d'une électrode inférieure, d'une couche d'un matériau piézoélectrique, et d'une électrode supérieure.

Un autre mode de réalisation de la présente invention prévoit une tranche sur laquelle sont formés des résonateurs BAW, chaque résonateur BAW comportant : au dessus d'un substrat, un résonateur piézoélectrique, à côté du résonateur piézoélectrique, au moins un plot de contact relié à une électrode du résonateur piézoélectrique et, entre le résonateur piézoélectrique et le substrat, un miroir de Bragg. Le miroir de Bragg comporte au moins une couche conductrice s'étendant entre le plot et le substrat, et au moins une couche supérieure d'oxyde de silicium s'étendant entre ledit plot et le substrat, ladite couche d'oxyde de silicium présentant une même épaisseur à mieux que 2 % près, et de préférence à mieux que 1 % près, au niveau de chaque plot. Chaque résonateur BAW comporte, superposée à la couche conductrice, une couche en un matériau de conductivité électrique supérieure à celle de la couche conductrice et d'impédance acoustique distincte de celle de la couche conductrice.

Selon un mode de réalisation de la présente invention, la couche conductrice est en tungstène et le matériau de conductivité électrique supérieure à celle de la couche conductrice est de l'aluminium.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1, précédemment décrite, est une vue en coupe représentant de façon schématique un résonateur BAW à miroir de Bragg ;
la figure 2, précédemment décrite, est une vue de dessus schématique du résonateur BAW de la figure 1 ;
la figure 3 illustre l'influence des plots de contact et des pistes d'interconnexion sur le facteur de qualité d'un résonateur BAW, autour de la fréquence d'antirésonance ;
la figure 4 est une vue en coupe représentant de façon schématique un exemple de réalisation d'un résonateur BAW à miroir de Bragg ;
la figure 5 illustre l'influence des plots de contact sur le facteur de qualité du résonateur BAW de la figure 4, autour de la fréquence d'antirésonance ;
la figure 6 illustre une étape d'un exemple de procédé de réalisation de résonateurs BAW à miroir de Bragg ;
la figure 7 est une vue en coupe représentant de façon schématique une variante de réalisation du résonateur BAW décrit en relation avec la figure 4 ; et
la figure 8 est une vue en coupe représentant de façon schématique une autre variante de réalisation du résonateur BAW décrit en relation avec la figure 4.

### Description détaillée

Par souci de clarté, de mêmes éléments ont été désignés par de mêmes références aux différentes figures et, de plus, comme cela est habituel dans la représentation des micro-composants, les diverses figures ne sont pas tracées à l'échelle.

Les inventeurs ont observé qu'il existe un couplage parasite entre les plots de contact, les pistes d'interconnexion, et le substrat. Il en résulte des fuites de courant dans le substrat. Ces fuites influent sur le comportement du résonateur BAW et dégradent notamment le facteur de qualité.

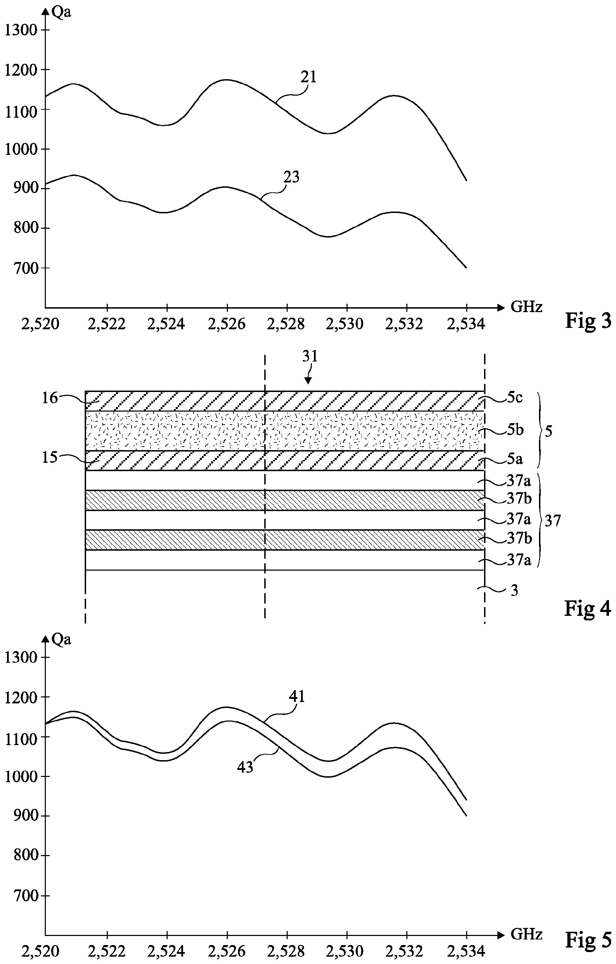

La figure 3 illustre l'influence des plots de contact et des pistes d'interconnexion sur le facteur de qualité d'un résonateur BAW, autour de la fréquence d'antirésonance.

Pour étudier cette influence, les inventeurs ont mesuré les caractéristiques électriques d'un dispositif témoin, comportant les plots et pistes conductrices habituellement prévus dans un résonateur BAW, mais ne comportant pas le résonateur lui-même.

Par simulation, à partir de la mesure du facteur de qualité d'un résonateur BAW réel, ils en ont déduit le facteur de qualité intrinsèque du résonateur BAW, c'est-à-dire le facteur de qualité théorique d'un résonateur BAW dans lequel l'influence des plots et pistes de connexion n'est pas considérée.

La courbe 21 représente l'évolution du facteur de qualité intrinsèque d'un résonateur BAW en fonction de la fréquence, autour de la fréquence d'antirésonance (de l'ordre de 2,5 GHz dans cet exemple).

La courbe 23 représente l'évolution du facteur de qualité réel d'un résonateur BAW en fonction de la fréquence, autour de la fréquence d'antirésonance.

On observe que le facteur de qualité réel est nettement plus faible que le facteur de qualité intrinsèque. Dans cet exemple, l'écart est de l'ordre de 30 %.

Un aspect d'un mode de réalisation de la présente invention est de prévoir un écran électriquement conducteur entre les plots et pistes de connexion et le substrat, de façon à minimiser ou supprimer les fuites de charge dans le substrat.

La figure 4 est une vue en coupe représentant de façon schématique un exemple de réalisation d'un résonateur BAW 31.

Comme dans le résonateur BAW 1 de la figure 1, un miroir de Bragg 37 fait interface entre le résonateur piézoélectrique 5 et le substrat 3. Le miroir de Bragg 37 consiste en un empilement alterné de couches 37a en un matériau à faible impédance acoustique et de couches 37b en un matériau à haute impédance acoustique.

On choisit un miroir de Bragg dans lequel au moins l'un des deux matériaux est électriquement conducteur. Dans cet exemple, les couches 37a sont en oxyde de silicium et les couches 37b sont en tungstène.

A la différence du résonateur 1 de la figure 1, les couches du résonateur 31 s'étendent sous les pistes d'interconnexion 15 et 16 et sous les plots de contact.

Le tungstène étant un matériau à forte conductivité électrique par rapport au substrat 3, il en résulte que les courants parasites, liés aux phénomènes de couplage capacitif avec les plots et pistes de connexion, ne passent plus par le substrat mais par les couches 37b.

La figure 5 illustre l'influence des plots de contact et des pistes d'interconnexion sur le facteur de qualité d'un résonateur BAW du type décrit en relation avec la figure 4, autour de la fréquence d'antirésonance.

La courbe 41 représente l'évolution du facteur de qualité intrinsèque du résonateur BAW en fonction de la fréquence, autour de la fréquence d'antirésonance

La courbe 43 représente l'évolution du facteur de qualité réel du résonateur BAW en fonction de la fréquence, autour de la fréquence d'antirésonance.

On observe que l'écart entre le facteur de qualité réel et le facteur de qualité intrinsèque est très faible. Dans cet exemple, il est de l'ordre de 2 % autour de la fréquence d'antirésonance.

Toutefois, les inventeurs ont constaté que le prolongement des couches conductrices du miroir de Bragg sous les plots de contact a une conséquence indésirable. Bien que ce prolongement protège le substrat des fuites de courant, il augmente fortement la valeur des capacités parasite liées aux plots de contact. Ces capacités ont notamment une influence sur l'impédance présentée par le résonateur et sur son comportement en température. On observe un décalage de la fréquence d'antiré-sonance, de l'ordre de 1 à 10 pour 1000, lié au prolongement des couches conductrices du miroir de Bragg.

Le décalage de fréquence à proprement parler n'est pas gênant, à condition qu'il soit connu. Cependant, les inventeurs ont observé que ce décalage varie entre des résonateurs BAW fabriqués à partir d'une même tranche de substrat, et a fortiori à partir de tranches différentes. De plus, la sensibilité de ce décalage à la température varie d'un résonateur à l'autre, à l'échelle d'une tranche.

En analysant les causes de ces imprécisions, les inventeurs ont remarqué que, parmi les différentes couches formant un résonateur BAW, les couches d'oxyde de silicium sont celles dont le dépôt est le plus imprécis. A titre d'exemple, on peut observer sur ces couches, à l'échelle d'une tranche de substrat, des variations d'épaisseur d'amplitude de l'ordre de 9 % (ou écart type de l'ordre de 2 %). De telles variations d'épaisseur ont une forte influence sur la valeur des capacités parasite liées aux plots de contact, ainsi que sur le comportement en température de ces capacités.

Un aspect d'un mode de réalisation de l'invention est de prévoir, lors de la fabrication, une étape consistant à uniformiser l'épaisseur de la couche supérieure d'oxyde de silicium de façon que cette couche présente, entre les plots et pistes de connexion et le substrat, une épaisseur constante à mieux que 2 % près (ou écart type de 0,5 %), et de préférence à mieux que 1 % près (ou écart type de l'ordre de 0,2 %), au niveau de chaque résonateur d'une même tranche ou de tranches différentes.

Selon une variante de réalisation, on prévoit également d'uniformiser l'épaisseur de cette couche supérieure d'oxyde de silicium entre le résonateur piézoélectrique 5 et le miroir de Bragg 37, de façon à optimiser le comportement en température du résonateur.

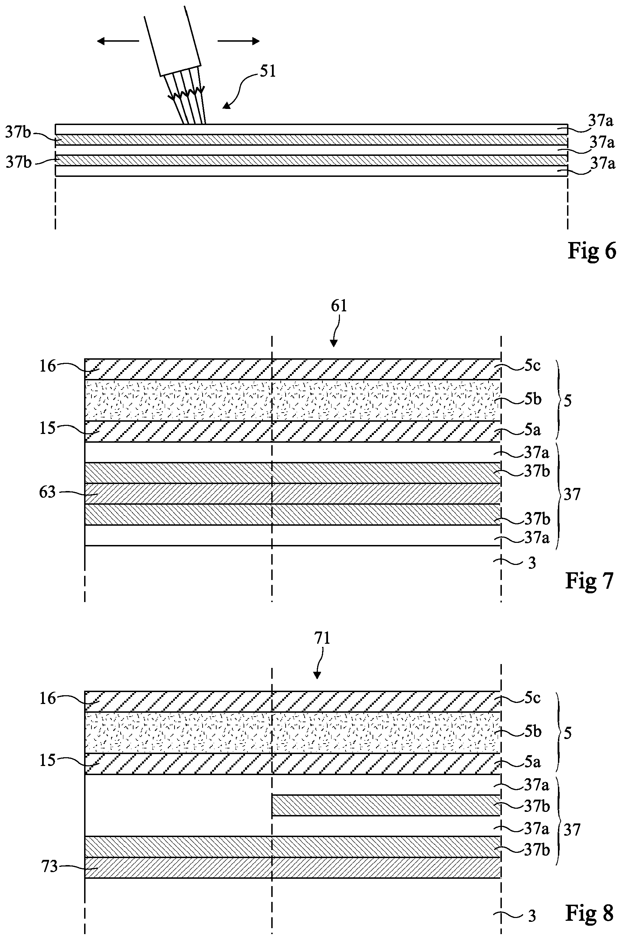

La figure 6 illustre une étape d'un exemple de procédé de réalisation de résonateurs BAW du type décrit en relation avec la figure 4. La figure 6 est une vue en coupe représentant de façon schématique une portion d'une tranche de substrat sur laquelle sont formés des éléments 37a, 37b d'un miroir de Bragg. Les couches 37a sont des couches d'oxyde de silicium et les couches 37b sont des couches de tungstène. La couche supérieure du miroir de Bragg est une couche d'oxyde de silicium.

Après le dépôt de la couche supérieure d'oxyde de silicium, il est prévu une étape d'uniformisation de l'épaisseur de cette couche par gravure des surépaisseurs liées au procédé de dépôt. Cette étape d'uniformisation d'épaisseur est réalisée par gravure ionique.

En effet, lors de la fabrication de résonateurs BAW, il est généralement prévu une étape finale d'ajustement de fréquence par gravure ionique d'une couche recouvrant le résonateur piézoélectrique (par exemple une couche de nitrure de silicium ou d'oxyde de silicium). Les moyens de gravure ionique sont donc déjà disponibles.

La tranche de substrat sur laquelle sont formés les résonateurs est balayée par un faisceau 51 d'ions de gravure de masse importante. La vitesse de balayage est contrôlée de façon à s'attarder sur les zones que l'on veut graver plus que les autres. A l'issue de l'étape d'uniformisation, la couche supérieure 37a présente une même épaisseur à mieux que 2 % près, et de préférence à mieux que 1 % près, au niveau de chaque région destinée à supporter des plots et pistes de connexion électrique d'un résonateur, ou au niveau de chaque résonateur.

Grâce à cette étape d'uniformisation, le décalage de fréquence lié aux capacités parasite des plots de contact est sensiblement le même pour tous les résonateurs fabriqués à partir d'une même tranche de substrat. En outre, le comportement en température de ce décalage est sensiblement constant à l'échelle d'une tranche de substrat.

La figure 7 est une vue en coupe représentant de façon schématique une variante de réalisation d'un résonateur BAW 61. A la différence du résonateur 31 de la figure 4, le résonateur 61 comporte, sous la couche de tungstène 37b la plus proche du résonateur piézoélectrique 5, une couche 63 en un matériau de conductivité électrique supérieure à celle du tungstène, par exemple de l'aluminium. A titre d'exemple, l'épaisseur de la couche d'aluminium pourra être de l'ordre de 500 à 700 nm, et l'épaisseur de la couche de tungstène pourra être de l'ordre de 500 à 800 nm pour une fréquence d'antirésonance de l'ordre de 2,5 GHz. Dans cet exemple, la couche d'oxyde intermédiaire 37a est remplacée par la couche 63 d'aluminium.

Un aspect d'un mode de réalisation de la présente invention consiste à améliorer la conductivité électrique d'au moins une couche du miroir de Bragg s'étendant entre les plots et pistes de connexion électrique et le substrat en prévoyant, en contact avec cette couche, une couche en un matériau à très forte conductivité électrique, par exemple de l'aluminium ou du cuivre. Le matériau et l'épaisseur de cette couche conductrice seront choisis de façon à ne pas ou peu dégrader les performances acoustiques du résonateur.

La prévision d'une telle couche présente l'avantage d'améliorer fortement le facteur de qualité du résonateur BAW. Dans le cas où la très grande précision de la fréquence de résonance ne serait pas indispensable, on pourra se passer de l'étape susmentionnée d'uniformisation d'épaisseur de la couche supérieure d'oxyde de silicium et se contenter de prévoir la couche très conductrice 63 pour obtenir un facteur de qualité élevé.

La figure 8 est une vue en coupe représentant de façon schématique une variante de réalisation d'un résonateur BAW 71. A la différence du résonateur 31 de la figure 4, le résonateur 71 comporte, sous de la couche de tungstène 37b la plus proche du substrat 3, une couche 73 en un matériau de conductivité électrique supérieure à celle du tungstène, par exemple de l'aluminium. De plus, la couche de tungstène supérieure 37b du miroir de Bragg comprise entre la couche 73 et le résonateur piézoélectrique ne s'étend pas sous les plots et pistes de connexion. La région comprise entre la couche inférieure de tungstène 37b et les plots et pistes de connexion 15 est constituée d'oxyde de silicium. Ce mode de réalisation cumule les avantages de diminuer les couplages parasites liés à la présence des plots et des pistes d'interconnexion, d'optimiser la réflexion acoustique, et d'augmenter le facteur de qualité du résonateur.

Selon un avantage des modes de réalisation décrits ci-dessus, l'invention pourra être mise en oeuvre en utilisant uniquement des procédés de fabrication standards.

Des modes de réalisation particuliers de la présente invention ont été décrits. Diverses variantes et modifications apparaîtront à l'homme de l'art.

En outre, l'invention ne se restreint pas à l'utilisation d'un miroir de Bragg comportant des couches de tungstène. Tout autre miroir de Bragg comportant au moins un matériau conducteur pourra être utilisé. Toutefois, on notera que les miroirs de Bragg composés d'une alternance de couches d'oxyde de silicium et de couches de tungstène présentent de bonnes propriétés réfléchissantes en raison du contraste élevé entre les impédances acoustiques de ces deux matériaux.

## Revendications

1. Procédé de fabrication d'une tranche sur laquelle sont formés des résonateurs BAW (31 ; 61 ; 71), chaque résonateur BAW comportant :
au dessus d'un substrat (3), un résonateur piézoélectrique (5), et à côté du résonateur piézoélectrique, au moins un plot de contact (13, 14) relié à une électrode du résonateur piézoélectrique ; et
entre le résonateur piézoélectrique (5) et le substrat (3), un miroir de Bragg (37),
dans lequel le miroir de Bragg comporte au moins une couche conductrice (37b) s'étendant entre ledit au moins un plot (13, 14) et le substrat (3), et au moins une couche supérieure d'oxyde de silicium (37a) s'étendant entre ledit au moins un plot et le substrat,
ce procédé comportant les étapes successives suivantes :
a) déposer la couche supérieure d'oxyde de silicium (37a) ; et
b) réduire, par gravure au moyen d'un faisceau d'ions balayant la tranche, les inégalités d'épaisseur de la couche supérieure d'oxyde de silicium (37a) liées au procédé de dépôt, de sorte que cette couche présente une même épaisseur à mieux que 2 % près, et de préférence à mieux que 1 % près, au niveau de chaque plot.

2. Procédé selon la revendication 1, dans lequel l'étape b) consiste en outre à réduire les inégalités d'épaisseur de la couche supérieure d'oxyde de silicium (37a) liées au procédé de dépôt, de sorte que cette couche présente une même épaisseur à mieux que 2 % près, et de préférence à mieux que 1 % près, au niveau de chaque résonateur piézoélectrique (5).

3. Procédé selon la revendication 1 ou 2, dans lequel ladite au moins une couche conductrice (37b) est en tungstène.

4. Procédé selon l'une quelconque des revendications 1 à 3, dans lequel chaque résonateur BAW comporte, superposée à ladite au moins une couche conductrice (37b), une couche (63 ; 73) en un matériau de conductivité électrique supérieure à celle de ladite au moins une couche conductrice (37b).

5. Procédé selon la revendication 4, dans lequel ledit matériau de conductivité électrique supérieure à celle de ladite au moins une couche conductrice est de l'aluminium.

6. Procédé selon l'une quelconque des revendications 1 à 5, dans lequel ledit résonateur piézoélectrique (5) est formé par empilement d'une électrode inférieure (5a), d'une couche d'un matériau piézoélectrique (5b), et d'une électrode supérieure (5c).

7. Tranche (31 ; 61 ; 71) sur laquelle sont formés des résonateurs BAW (61 ; 71), chaque résonateur BAW comportant :
au dessus d'un substrat (3), un résonateur piézoélectrique (5), et à côté du résonateur piézoélectrique, au moins un plot de contact (13, 14) relié à une électrode du résonateur piézoélectrique ; et
entre le résonateur piézoélectrique (5) et le substrat (3), un miroir de Bragg (37),
dans laquelle le miroir de Bragg comporte au moins une couche conductrice (37b) s'étendant entre ledit au moins un plot (13, 14) et le substrat (3), **caractérisé en ce que** la tranche comprenne additionnellement au moins une couche supérieure d'oxyde de silicium (37a) s'étendant entre ledit plot et le substrat, ladite couche d'oxyde de silicium (37a) présentant une même épaisseur à mieux que 2% près et de préférence à mieux 1% près au niveau de chaque plot.

8. Tranche (61 ; 71) selon la revendication 7, dans laquelle chaque résonateur BAW comporte, superposée à ladite au moins une couche conductrice (37b), une couche (63 ; 73) en un matériau de conductivité électrique supérieure à celle de ladite au moins une couche conductrice (37b) et d'impédance acoustique distincte de celle de ladite au moins une couche conductrice.

9. Tranche selon la revendication 8, dans laquelle ladite au moins une couche conductrice (37b) est en tungstène et ledit matériau de conductivité électrique supérieure à celle de ladite au moins une couche conductrice est de l'aluminium.

## Patentansprüche

1. Verfahren zur Herstellung eines Wafers, auf dem BAW-Resonatoren (31; 61; 71) ausgebildet sind, wobei jeder BAW-Resonator aufweist:
über einem Substrat (3) einen piezoelektrischen Resonator (5), und neben dem piezoelektrischen Resonator wenigstens ein Kontaktstück (13, 14), das mit einer Elektrode des piezoelektrischen Resonators verbunden ist; und
zwischen dem piezoelektrischen Resonator (5) und dem Substrat (3) einen Bragg-Spiegel (37),
wobei der Bragg-Spiegel wenigstens eine leitende Schicht (37b), die sich zwischen dem wenigstens einen Kontaktstück (13, 14) und dem Substrat (3) erstreckt, und wenigstens eine obere Schicht aus Siliciumoxid (37a), die sich zwischen dem wenigstens einen Kontaktstück und dem Substrat erstreckt, aufweist,
wobei dieses Verfahren die folgenden aufeinander folgenden Schritte umfasst:
a) Aufbringen der oberen Schicht aus Siliciumoxid (37a); und
b) Verringern, durch Ätzung mittels eines den Wafer überstreichenden Ionenstrahls, der mit dem Aufbringungsverfahren zusammenhängenden Dickenungleichheiten der oberen Schicht aus Siliciumoxid (37a), derart, dass diese Schicht an jedem Kontaktstück mit einer Genauigkeit von mehr als 2 % und vorzugsweise von mehr als 1 % dieselbe Dicke aufweist.

2. Verfahren nach Anspruch 1, wobei der Schritt b) außerdem darin besteht, die mit dem Aufbringungsverfahren zusammenhängenden Dickenungleichheiten der oberen Schicht aus Siliciumoxid (37a) zu verringern, derart, dass diese Schicht an jedem piezoelektrischen Resonator (5) mit einer Genauigkeit von mehr als 2 % und vorzugsweise von mehr als 1 % dieselbe Dicke aufweist.

3. Verfahren nach Anspruch 1 oder 2, wobei die wenigstens eine leitende Schicht (37b) aus Wolfram besteht.

4. Verfahren nach einem der Ansprüche 1 bis 3, wobei jeder BAW-Resonator eine der wenigstens einen leitenden Schicht (37b) überlagerte Schicht (63; 73) aus einem Material mit einer spezifischen elektrischen Leitfähigkeit aufweist, die höher als diejenige der wenigstens einen leitenden Schicht (37b) ist.

5. Verfahren nach Anspruch 4, wobei das Material mit einer spezifischen elektrischen Leitfähigkeit, die höher als diejenige der wenigstens einen leitenden Schicht ist, Aluminium ist.

6. Verfahren nach einem der Ansprüche 1 bis 5, wobei der piezoelektrische Resonator (5) durch Stapelung einer unteren Elektrode (5a), einer Schicht eines piezoelektrischen Materials (5b) und einer oberen Elektrode (5c) gebildet wird.

7. Wafer (31; 61; 71), auf dem BAW-Resonatoren (61; 71) ausgebildet sind, wobei jeder BAW-Resonator aufweist:
über einem Substrat (3) einen piezoelektrischen Resonator (5), und neben dem piezoelektrischen Resonator wenigstens ein Kontaktstück (13, 14), das mit einer Elektrode des piezoelektrischen Resonators verbunden ist; und
zwischen dem piezoelektrischen Resonator (5) und dem Substrat (3) einen Bragg-Spiegel (37),
wobei der Bragg-Spiegel wenigstens eine leitende Schicht (37b) aufweist, die sich zwischen dem wenigstens einen Kontaktstück (13, 14) und dem Substrat (3) erstreckt,
**dadurch gekennzeichnet, dass** der Wafer außerdem wenigstens eine obere Schicht aus Siliciumoxid (37a) umfasst, die sich zwischen dem Kontaktstück und dem Substrat erstreckt, wobei diese Siliciumoxidschicht (37a) an jedem Kontaktstück mit einer Genauigkeit von mehr als 2 % und vorzugsweise von mehr als 1 % dieselbe Dicke aufweist.

8. Wafer (61; 71) nach Anspruch 7, wobei jeder BAW-Resonator eine der wenigstens einen leitenden Schicht (37b) überlagerte Schicht (63; 73) aus einem Material mit einer spezifischen elektrischen Leitfähigkeit, die höher als diejenige der wenigstens einen leitenden Schicht (37b) ist, und mit einer akustischen Impedanz, die von derjenigen der wenigstens einen leitenden Schicht verschieden ist, aufweist.

9. Wafer nach Anspruch 8, wobei die wenigstens eine leitende Schicht (37b) aus Wolfram besteht und das Material mit einer spezifischen elektrischen Leitfähigkeit, die höher als diejenige der wenigstens einen leitenden Schicht ist, Aluminium ist.

## Claims

1. A method for manufacturing a wafer on which are formed BAW resonators (31; 61; 71), each BAW resonator comprising:
above a substrate (3), a piezoelectric resonator (5), and next to the piezoelectric resonator, at least one contact pad (13, 14) connected to an electrode of the piezoelectric resonator; and
between the piezoelectric resonator (5) and the substrate (3), a Bragg mirror (37),
wherein the Bragg mirror comprises at least one conductive layer (37b) extending between said at least one pad (13, 14) and the substrate (3) and at least one upper silicon oxide layer (37a) extending between said at least one pad and the substrate,
this method comprising the successive steps of:
a) depositing the upper silicon oxide layer (37a); and
b) decreasing, by etching, by means of an ion beam, the thickness unevenness of the upper silicon oxide layer (37a) due to the deposition method so that this layer has a same thickness to within better than 2%, and preferably to within better than 1%, at the level of each pad.

2. The method of claim 1, wherein step b) further comprises decreasing the thickness unevenness of the upper silicon oxide layer (37a) due to the deposition method, so that this layer has a same thickness to within better than 2%, and preferably to within better than 1%, at the level of each piezoelectric resonator (5).

3. The method of claim 1 or 2, wherein said at least one conductive layer (37b) is made of tungsten.

4. The method of any of claims 1 to 3, wherein each BAW resonator comprises, superposed to said at least one conductive layer (37b), a layer (63; 73) of a material having an electric conductivity greater than that of said at least one conductive layer (37b).

5. The method of claim 4, wherein the material of electric conductivity greater than that of said at least one conductive layer is aluminum.

6. The method of any of claims 1 to 5, wherein said piezoelectric resonator (5) is formed by stacking of a lower electrode (5a), of a layer of a piezoelectric material (5b), and of an upper electrode (5c).

7. A wafer (31; 61; 71) on which are formed BAW resonators (61; 71), each BAW resonator comprising:
above a substrate (3), a piezoelectric resonator (5), next to the piezoelectric resonator, at least one contact pad (13, 14) connected to an electrode of the piezoelectric resonator; and
between the piezoelectric resonator (5) and the substrate (3), a Bragg mirror (37),
wherein the Bragg mirror comprises at least one conductive layer (37b) extending between said at least one pad (13, 14) and the substrate (3), **characterized in that** the wafer further comprises at least one upper silicon oxide layer (37a) extending between said pad and the substrate, said silicon oxide layer (37a) having a same thickness to within better than 2%, and preferably to within better than 1%, at the level of each pad.

8. The wafer (61; 71) of claim 7, and wherein each BAW resonator comprises, superposed to said at least one conductive layer (37b), a layer (63; 73) of a material having an electric conductivity greater than that of said at least one conductive layer (37b) and an acoustic impedance different from that of said at least one conductive layer.

9. The wafer of claim 8, wherein said at least one conductive layer (37b) is made of tungsten and said material having an electric conductivity greater than that of said at least one conductive layer is aluminum.
